# EUROPÄISCHE PATENTSCHRIFT

(11) **EP 1 034 617 B1**
(45) Veröffentlichungstag und Bekanntmachung des Hinweises auf die Patenterteilung: **19.03.2003**
(21) Anmeldenummer: 98962390.5
(22) Anmeldetag: 24.11.1998
(51) Int. Cl.: H03H 11/22

(54) **BREITBAND-PHASENSCHIEBERSCHALTUNG**
BROADBAND PHASE-SHIFTING CIRCUIT
CIRCUIT DE DEPHASAGE A LARGE BANDE

(30) Priorität: 25.11.1997 DE 19752206
(43) Veröffentlichungstag der Anmeldung: 13.09.2000
(73) Patentinhaber: Rohde & Schwarz GmbH & Co. KG, D-81671 München (DE)
(72) Erfinder: KLIER, Johann, D-82008 Unterhaching (DE)
(74) Vertreter: Graf, Walter, Dipl.-Ing.
(86) Internationale Anmeldenummer: EP9807569
(87) Internationale Veröffentlichungsnummer: WO99027648

(56) Entgegenhaltungen:
- EP-A- 0 645 885
- DE-A- 4 420 376
- US-A- 4 558 291

## Beschreibung

Die Erfindung betrifft eine Breitband-Phasenschieberschaltung laut Oberbegriff des Hauptanspruches.

Breitband-Phasenschieberschaltungen dieser Art sind bekannt, sie werden beispielsweise als 90°-Phasenschieber für IQ-Modulatoren benutzt (beispielsweise nach US-Patenten 4,908,532, 4,951,000 oder 5,644,260). Sie besitzen jeweils unterschiedliche Nachteile. Die Ausbildung der Phasenschieber als RC-Glieder mit veränderbaren Kapazitätsdioden und deren Regelung über einen zwischen den Ausgängen angeschalteten Phasendetektor (US-Patent 4,908,532) hat unbestimmte Amplituden der Ausgangsspannungen an den beiden Phasenschieberzweigen zur Folge. Die unterschiedlichen Amplituden beeinträchtigen den nachfolgenden IQ-Modulator in der Modulationsgenauigkeit. Die entgegengesetzte Phasenkorrektur von zwei gleichartigen Phasenschiebern in den beiden Phasenschieberzweigen über einen Phasendetektor (US-Patent 4,951,000) ist auf spezielle Phasenschieber eingeschränkt und kann beispielsweise nicht bei einfachen RC-Gliedern angewendet werden. Die Regelung der beiden Phasenschieberzweige in Abhängigkeit von der Differenz der Amplitude der beiden Ausgangsspannungen (US-Patent 5,644,260) ist bezüglich der Einhaltung der gewünschten exakten Phasenbeziehung nicht genau genug.

Es ist daher Aufgabe der Erfindung, eine Breitband-Phasenschieberschaltung zu schaffen, die diese Nachteile vermeidet und in einem breiten Frequenzbereich unabhängig von der Art der verwendeten Phasenschieber die exakte Einhaltung des gewünschten Phasenwinkels bei jeweils gleich großen Amplituden der Ausgangsspannungen gewährleistet.

Diese Aufgabe wird ausgehend von einer Breitband-Phasenschieberschaltung laut Oberbegriff des Hauptanspruches durch dessen kennzeichnende Merkmale gelöst. Vorteilhafte Weiterbildungen ergeben sich aus den Unteransprüchen.

Eine Phasenschieberschaltung mit den Merkmalen des Oberbegriffs ist bekannt, z.B. aus dem Dokument DE-A-4 420 376.

Bei der erfindungsgemäßen Phasenschieberschaltung wird ein Phasenschieberzweig in Abhängigkeit von der Frequenz des Eingangssignals grob auf einen Wert eingestellt, der in etwa dem gewünschten vorbestimmten Phasenwinkel entspricht. Nur der zweite Phasenschieberzweig wird über einen Phasendetektor so fein nachgeregelt, daß schließlich der gewünschte vorbestimmte Phasenwinkel, beispielsweise 90° erreicht wird. Dieses Prinzip von grober Voreinstellung und feiner Nachregelung ist für alle möglichen Phasenschieber geeignet, sowohl für einfache RC-Glieder als auch für Allpaßglieder, Laufzeitglieder oder auch Phasenschieberschaltungen unter Verwendung von Induktivitäten. Voraussetzung ist lediglich, daß die verwendeten Phasenschieber in den beiden Phasenschieberzweigen jeweils so dimensionierbar sind, daß die Ausgangssignale an ihren beiden Ausgängen jeweils den gewünschten Phasenwinkel aufweisen. Da gemäß der Erfindung über den Phasendetektor unmittelbar in Abhängigkeit von der Phase feingeregelt wird und nicht über den Umweg eines Amplitudenvergleiches ist die Schaltung auch unempfindlich gegen über Temperatureffekten und Alterungen der Bauelemente. Durch die kombinierte Grobsteuerung/Feinregelung vorzugsweise über variable Widerstände in den Phasenschiebern der Zweige ist eine erfindungsgemäße Phasenschieberschaltung extrem breitbandig über bis zu zwei Frequenzdekaden.

Die Erfindung wird im folgenden anhand schematischer Zeichnungen an einem Ausführungsbeispiel näher erläutert.

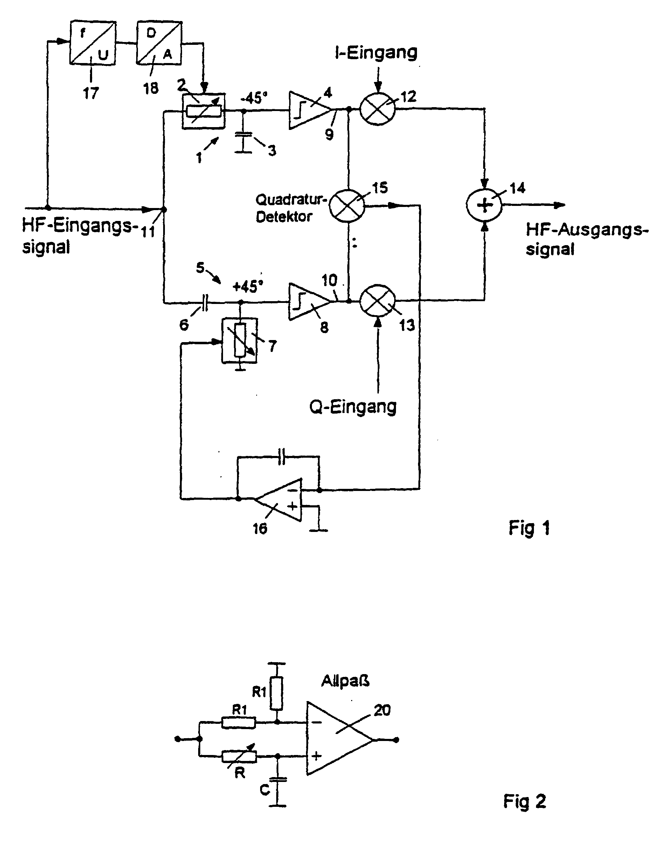

Fig. 1 zeigt das Prinzipschaltbild einer erfindungsgemäßen Breitband-Phasenschieberschaltung und zwar angewendet bei einem IQ-Modulator. Der eine Phasenschieberzweig 1 wird durch einen Tiefpaß mit einem variablen Widerstand 2 und einem festen Kondensator 3 nebst nachgeschaltetem Begrenzer 4 gebildet, der andere Phasenschieberzweig 5 durch einen Hochpaß mit einem festen Kondensator 6, einem variablen Widerstand 7 und einem nachgeschalteten Begrenzer 8. Der Tiefpaß erzeugt eine Phasenverschiebung von -45°, der Hochpaß eine Phasenverschiebung von +45°. Ein am gemeinsamen Eingang 11 zugeführtes HF-Eingangssignal wird über die beiden Phasenschieberzweige 1 und 5 in zwei Ausgangssignalkomponenten an den Ausgängen 9 und 10 aufgeteilt, die gegeneinander exakt 90°-Phasenverschiebung aufweisen. Der Ausgang 9 ist mit dem Mischer 12 für den I-Eingang verbunden, der Ausgang 10 mit dem Mischer 13 für den Q-Eingang des IQ-Modulators. Die Ausgänge der Mischer sind in einem Addierer 14 zusammengefaßt. Der 90°-Phasenschieber erzeugt die beiden um 90° gegeneinander phasenverschobenen Signalkomponenten des am Eingang 11 zugeführten Trägersignals.

Zwischen den Ausgängen 9 und 10 der Begrenzer ist ein Phasendetektor 15, beispielsweise ein Multiplizierer angeschaltet, dessen Ausgang über einen Regelverstärker 16 mit dem veränderbaren Widerstand 7 des Hochpasses verbunden ist. Der veränderbare Widerstand des Tießpasses wird in Abhängigkeit von der Frequenz des HF-Eingangssignals gesteuert. Die beiden veränderbaren Widerstände 2 und 7 werden beispielsweise durch die Drain-Source-Strecke eines Feldeffekttransistors gebildet, der über den Gate-Anschluß veränderbar ist.

Die Steuerung des Widerstandes 2 in Abhängigkeit von der Frequenz erfolgt über einen Speicher 17, in welchem für die Frequenzwerte f des HF-Eingangssignals die zugehörigen Steuergrößen U für den Widerstand 2 als Digitalwerte abgespeichert sind. Die jeweils in Abhängigkeit von der Eingangsfrequenz f ausgewählte Steuergröße U wird über einen Digital-Analog-Wandler 18 in eine entsprechende analoge Steuergröße für den Widerstand 2, beispielsweise die Gate-Steuerspannung für einen Feldeffekttransistor, umgesetzt. Die Eingabe des jeweiligen Frequenzwertes f kann im einfachsten Fall bei konstanter Eingangsfrequenz von Hand über den Benutzer erfolgen, bei wechselnder Frequenz kann ein entsprechender Frequenzmesser benutzt werden. In den meisten Fällen liegt bei solchen Anwendungsfällen die Frequenz des HF-Eingangssignals als digitaler Wert vor und mit diesem kann dann unmittelbar aus dem Speicher 17 die zugehörige Steuergröße U ausgelesen werden.

Über den Widerstand 2 wird der Tiefpaß grob auf einen Wert voreingestellt, der etwa eine Phasenverschiebung von -45° mit einer Genauigkeit von ±5° ergibt. Über den Regelkreis des Phasendetektors 15 wird dann der Widerstand 7 des Hochpasses so nachgeregelt, daß die Ausgangssignale an den Ausgängen 9 und 10 die gewünschte exakte 90°-Phasenverschiebung aufweisen, der Ausgang des Phasendetektors also die Regelgröße 0 liefert. Nach dem erfindungsgemäßen Prinzip kann nicht nur eine gegenseitige 90°-Phasenverschiebung exakt eingestellt werden, sondern jeder beliebige Phasenwinkel zwischen 0 und 180°. Dies kann beispielsweise auf einfache Weise dadurch geschehen, daß am +-Eingang des Regelverstärkers 16 eine entsprechende Vergleichsspannung angelegt wird und dann die Phase zwischen den Ausgangssignalen auf diesen vorgegebenen Spannungsoffset geregelt wird.

Die Größe der Frequenzschritte, unter den die jeweiligen Steuergrößen U im Speicher 17 abgespeichert sind, richtet sich nach der gewünschten Genauigkeit. Der Zusammenhang zwischen Frequenz f und Steuergröße U wird vorzugsweise über einen einmaligen Kalibriervorgang ermittelt, in dem für verschiedene Frequenzstützwerte innerhalb der Bandbreite, in welcher der Phasenschieber betrieben werden soll, in Schritten von etwa 10 % Frequenzänderung jeweils die zugehörigen Steuergrößen U ermittelt werden.

Anstelle der RC- bzw. CR-Glieder 2, 3 bzw. 6, 7 können in den beiden Phasenschieberzweigen 1 und 5 auch Allpässe eingesetzt werden. Das Prinzipschaltbild eines solchen Allpasses zeigt Fig. 2. Allpässe haben den Vorteil, daß der Ausgangspegel unabhängig von der Frequenz oder Phasenverschiebung konstant bleibt. Wegen des konstanten Frequenzganges eines Allpasses muß nicht mehr ein bestimmter Arbeitspunkt eingehalten werden, wie dies bei RC-Gliedern der Fall ist. Dadurch kann mit der gleichen Variation der Widerstände ein größerer Frequenzbereich abgedeckt werden.

Bei einem Allpaß nach Fig. 2 ist der Betrag der Verstärkung gleich 1, wenn der Differenzverstärker 20 eine Verstärkung von zwei hat. Dann ist bei tiefen Frequenzen die Verstärkung +1 und bei hohen Frequenzen -1. Durch Variation des Widerstandes R kann eine Phasenverschiebung zwischen 0° und -180° eingestellt werden, ohne die Amplitude zu beeinflussen. Die Phasenverschiebung beträgt ϕ = -2 arctan(2 π fR C).

Die beiden Grenzfrequenzen der in den beiden Phasenschieberzweigen 1 und 5 eingesetzten Allpässe werden vorzugsweise so weit voneinander verschoben, daß sich mit genügender Reserve noch mindestens die gewünschte Phasendifferenz einstellen läßt. Durch die Unabhängigkeit von der Amplitude kann der Allpaß im ersten Phasenschieberzweig 1 in viel gröberen Schritten eingestellt werden, es muß nur die Differenzphase den gewünschten Wert von z.B. 90° erreicht werden. Es ist beispielsweise möglich, den ersten Allpaß im Phasenschieberzweig 1 auf -5° einzustellen und den Allpaß im Phasenschieberzweig 5 über die Regelschleife auf -95° zu regeln. Bei einer Frequenzänderung ändert sich die Phase im Phasenschieberzweig 1 ohne neue Voreinstellung auf z.B. -50°. Die Regelung stellt den zweiten Allpaß im Phasenschieberzweig 5 auf -140° ein. Solange der Regelbereich des Allpasses im Phasenschieberzweig 5 noch ausreicht, braucht die Voreinstellung nicht geändert werden.

Ein solcher mit Allpässen aufgebauter Phasenschieber kann also beispielsweise breitbandig durch Verändern der Widerstände über eine Dekade in einem Frequenzbereich von 100 MHz bis 5 GHz breitbandig betrieben werden.

Die Allpässe in den beiden Zweigen 1 und 5 sind jeweils von gleicher Struktur und beispielsweise nach Fig. 2 aufgebaut, lediglich ihre Grenzfrequenz ist entsprechend unterschiedlich gewählt. Anstelle der Grobsteuerung und Feinregelung über den Widerstand R kann auch bei den Allpässen die jeweilige Steuerung und Regelung über eine Veränderung der Kapazität C erfolgen, die beispielsweise als Kapazitätsdioden ausgebildet sind. Dies ist auch bei den RC-Gliedem 2, 3 bzw. 6, 7 nach Fig. 1 möglich, auch hier könnten anstelle der veränderbaren Widerstände veränderbare Kapazitätsdioden eingesetzt werden. Auch eine Mischung dieser Steuer- und Regelmöglichkeiten ist denkbar. Die Phasenschieber könnten auch als RL-Glieder mit veränderbaren Widerständen oder veränderbaren Induktivitäten aufgebaut sein.

## Patentansprüche

1. Breitband-Phasenschieber-Schaltung, insbesondere für einen IQ-Modulator, mit zwei parallelgeschalteten Phasenschieberzweigen, denen eingangsseitig das in der Phase zu schiebende Eingangssignal zugeführt wird und die an Ihren Ausgängen (9, 10) um einen vorbestimmten Winkel, insbesondere um 90°, phasenverschobene Ausgangssignale liefern,
**dadurch gekennzeichnet,**
**daß** der Phasenschieber des einen Phasenschieberzweiges (1) in Abhängigkeit von der Frequenz (f) des Eingangssignales so gesteuert ist, daß der Phasenwinkel zwischen den beiden Ausgangssignalen in etwa dem gewünschten Wert entspricht
und der Phasenschieber des anderen Phasenschieberzweiges (5) über einen zwischen den Ausgängen der beiden Phasenschieberzweige geschalteten Phasendetektor (15) auf den gewünschten Phasenwinkel geregelt ist

2. Phasenschieberschaltung nach Anspruch 1,
**dadurch gekennzeichnet,**
**daß** der eine Phasenschieber durch ein RC-Tiefpaßglied (1) und der andere durch ein RC-Hochpaßglied (5) gebildet ist.

3. Phasenschieberschaltung nach Anspruch 1,
**dadurch gekennzeichnet,**
**daß** in den Phasenschieberzweigen (1, 5) jeweils Allpässe als Phasenschieber vorgesehen sind.

4. Phasenschieberschaltung nach Anspruch 2 oder 3,
**dadurch gekennzeichnet,**
**daß** die Grobsteuerung und Feinregelung jeweils über veränderbare Widerstände (2, 7 bzw. R) der RC-Glieder bzw. der Allpässe erfolgt.

5. Phasenschieberschaltung nach Anspruch 4,
**dadurch gekennzeichnet,**
**daß** die veränderbaren Widerstände (2, 7 bzw. R) der RC-Glieder bzw. der Allpässe durch die Drain-Source-Strecken von Feldeffekttransistoren gebildet sind.

6. Phasenschieberschaltung nach Anspruch 2 oder 3,
**dadurch gekennzeichnet,**
**daß** die Grobsteuerung und Feinregelung jeweils über veränderbare Kapazitäten der RC-Glieder bzw. der Allpässe erfolgt.

7. Phasenschieberschaltung nach Anspruch 1,
**dadurch gekennzeichnet,**
**daß** die Phasenschieber der beiden Phasenschieberzweige (1, 5) durch RL-Glieder mit veränderbaren Widerständen und/oder veränderbaren Induktivitäten gebildet sind.

8. Phasenschieberschaltung nach einem der vorhergehenden Ansprüche,
**dadurch gekennzeichnet,**
**daß** die der jeweiligen Frequenz (f) zugehörigen Steuergrößen (U) für die Grobsteuerung in einem Speicher (17) gespeichert und in Abhängigkeit von der Frequenz des Eingangssignals aus diesem auslesbar sind.

## Claims

1. Broadband phase-shifter circuit in particular for an IQ modulator with two parallel-connected phase-shifter branches, to which on the input side is supplied the input signal to be phase-shifted and which at their outputs (9, 10) supply output signals phase-offset by a predetermined angle, in particular 90°, **characterised in that** the phase-shifter of the one phase-shifter branch (1) is controlled as a function of the frequency (f) of the input signal so that the phase angle between the two output signals corresponds approximately to the desired value, and the phase-shifter of the other phase-shifter branch (5) is adjusted to the required phase angle via a phase detector (15) connected between the outputs of the two phase-shifter branches.

2. Phase-shifter circuit according to claim 1, **characterised in that** the one phase-shifter is formed by an RC low-pass element (1) and the other by an RC high-pass element (5).

3. Phase-shifter circuit according to claim 1, **characterised in that** in the phase-shifter branches (1, 5), all-passes are provided as phase-shifters.

4. Phase-shifter circuit according to claim 2 or 3, **characterised in that** the rough control and fine tuning each take place via variable resistors (2, 7 or R) of the RC elements or all-passes.

5. Phase-shifter circuit according to claim 4, **characterised in that** the modifiable resistors (2, 7 or R) of the RC elements or all-passes are formed by the drain-source sections of field effect transistors.

6. Phase-shifter circuit according to claim 2 or 3, **characterised in that** the rough control and fine tuning take place via variable capacitors of the RC elements or all-passes.

7. Phase-shifter circuit according to claim 1, **characterised in that** the phase-shifters of the two phase-shifter branches (1, 5) are formed by RL elements with modifiable resistors and/or modifiable inductances.

8. Phase-shifter circuit according to any of the previous claims, **characterised in that** the control values (U) associated with the respective frequency (f) for the rough control are stored in a memory (17) and can be read from this as a function of the frequency of the input signal.

## Revendications

1. Circuit de déphasage à large bande, notamment pour un moduleur IQ, comportant deux branches en parallèle, auxquelles est amené côté entrée le signal d'entrée à déphaser, et qui délivrent, sur leurs sorties (9, 10), des signaux de sortie déphasés d'un angle prédéterminé, notamment de 90°, **caractérisé en ce que**
le déphaseur d'une des branches (1) du circuit de déphasage est commandé en fonction de la fréquence (f) du signal d'entrée de telle sorte que l'angle de phase entre les deux signaux de sortie corresponde approximativement à la valeur désirée, et
le déphaseur de l'autre branche (5) du circuit de déphasage est réglé sur l'angle de phase désiré au moyen d'un détecteur de phase (15) branché entre les sorties des deux branches du circuit de déphasage.

2. Circuit de déphasage selon la revendication 1, **caractérisé en ce qu'**un déphaseur est formé par un circuit de filtre passe-bas RC (1) et l'autre déphaseur est formé par un circuit de filtre passe-haut RC (5).

3. Circuit de déphasage selon la revendication 1, **caractérisé en ce que** chaque fois des filtres passe-tout sont prévus comme déphaseurs dans les branches (1, 5) du circuit de déphasage.

4. Circuit de déphasage selon la revendication 2 ou 3, **caractérisé en ce que** la commande approximative et la commande précise sont réalisées respectivement au moyen de résistances variables (2, 7 ou R) des circuits RC ou des filtres passe-tout.

5. Circuit de déphasage selon la revendication 4, **caractérisé en ce que** les résistances variables (2, 7 ou R) des circuits RC ou des filtres passe-tout sont formées par les intervalles drain-source de transistors à effet de champ.

6. Circuit de déphasage selon la revendication 2 ou 3, **caractérisé en ce que** la commande approximative et la régulation précise s'effectuent respectivement au moyen de capacités variables des circuits RC ou des filtres passe-tout.

7. Circuit de déphasage selon la revendication 1, **caractérisé en ce que** les déphaseurs des deux branches (1, 5) du circuit de déphasage sont formés par des circuits RL comportant des résistances variables et/ou des inductances variables.

8. Circuit de déphasage selon l'une des revendications précédentes, **caractérisé en ce que** les grandeurs de commande (U) associées à la fréquence respective (f) pour la commande approximative sont mémorisées dans une mémoire (17) et sont lisibles dans cette mémoire en fonction de la fréquence du signal d'entrée.
